Europäisches Patentamt

**European Patent Office**

Office européen des brevets

(11) Numéro de publication: **0 267 826 B1**

# FASCICULE DE BREVET EUROPEEN

(12)

(45) Date de publication de fascicule du brevet: **11.03.92** (51) Int. Cl.⁵: **G06K 19/06**, G06K 19/077, H01L 21/56

(21) Numéro de dépôt: **87402286.6**

(22) Date de dépôt: **13.10.87**

(54) **Procédé de réalisation de cartes à mémoire électronique et cartes obtenues par la mise en oeuvre dudit procédé.**

(30) Priorité: **14.10.86 FR 8614231**

(43) Date de publication de la demande:
**18.05.88 Bulletin 88/20**

(45) Mention de la délivrance du brevet:
**11.03.92 Bulletin 92/11**

(84) Etats contractants désignés:
**AT BE CH DE ES FR GB GR IT LI LU NL SE**

(56) Documents cités:
**FR-A- 2 520 541
FR-A- 2 579 799
US-A- 3 553 787**

**JAPANESE PATENTS REPORT, Section CH:
Chemical, vol. 77, no. 42, 18 novembre 1977,
Derwent Publications Ltd, Londres, GB,
"class A", page 97, & JP-B-77 040 661
(MITSUBISHI) 13-10-1977**

**"Polyvinyl Chloride", H.A. Sarvetnivk, Robert
E. Kreiger Publishing Company, 1977**

**"Kunststoff Taschenbuch", Saechtling, 22.**

**Ausgabe, Hauser Verlag**

(73) Titulaire: **SCHLUMBERGER INDUSTRIES
50, avenue Jean Jaurès
F-92120 Montrouge(FR)**

(72) Inventeur: **Brignet, Marc
15, avenue Laurmière
F-75019 Paris(FR)**
Inventeur: **Droche, Emile
10, rue Alsace Lorraine
F-92250 La Garenne Colombes(FR)**

(74) Mandataire: **Hasenrader, Hubert et al
Cabinet BEAU DE LOMENIE 55, rue d'Amsterdam
F-75008 Paris(FR)**

## Description

La présente invention concerne un procédé de réalisation de cartes notamment à mémoire électronique.

Les cartes à mémoire comprennent essentiellement un corps de carte qui est réalisé en général en un matériau plastique et un module mémoire.Dans le cas des cartes à mémoire électronique le module mémoire est un module électronique comportant essentiellement une pastille semi-conductrice ou "chip" dans laquelle est réalisé un circuit intégré et un élément de circuit imprimé sur lequel est fixé le chip et qui définit les plages externes de contact . Le module électronique est fixé dans le corps de la carte de telle manière que les plages de contact électrique affleurent une des faces principales du corps de carte.

Le corps de carte a la forme d'un parallèlèpipède rectangle dont l'épaisseur doit être inférieure à 1 mm. Les bords du corps de carte servent de référence pour le positionnement de la carte dans le lecteur de cartes de telle manière que les plages de contact de la carte viennent en contact électrique avec le connecteur du lecteur de cartes.

Deux techniques principales sont utilisées pour réaliser le corps de carte et l'implantation du module électronique dans le corps de carte. Selon une première technique le corps de carte est réalisé par laminage à chaud de plusieurs feuilles de matériau plastique tel que du PVC. Le module électronique est mis en place dans l'empilement de feuilles de matériau plastique avant le laminage. Après l'opération de laminage, le module électronique est solidement ancré dans le corps de la carte. Ce procédé présente l'avantage de réaliser en une seule étape le corps de carte et l'implantation du module électronique dans le corps de carte. En revanche ce procédé est délicat et il nécessite le réusinage de la périphérie du corps de carte.

La deuxième technique consiste à réaliser le corps de carte dans une première étape, à usiner une cavité dans le corps de carte pour recevoir le module électronique et à coller le module électronique dans la cavité. L'usinage d'un tel corps de carte est toujours une opération délicate, donc onéreuse, car des cotes très précises doivent être respectées notamment pour assurer un positionnement correct du module électronique par rapport aux bords de la carte et par rapport à la face principale cu corps de carte dans laquelle doivent affleurer les plages de contact électrique. Le document FR-A-2 579 799 illustre un tel procédé.

Il faut ajouter que le corps de carte doit en outre répondre à d'autres spécifications concernant la qualité de l'état de surface et les propriétés de tenue en flexion bien précises aussi bien selon la direction longitudinale du corps de carte que selon sa direction transversale.De plus il faut que le corps de carte ne favorise pas le stockage de charges électrostatiques.

Un objet de la présente invention est de fournir un procédé de réalisation de cartes à mémoire électronique et en particulier de corps de carte qui permette d'abaisser le coût de fabrication du corps de carte et qui de plus simplifie l'opération de fixation du module électronique dans le corps de carte, tout en répondant aux spécifications énoncées ci-dessus.

Pour atteindre ce but, selon l'invention, le procédé de réalisation de carte comprend les étapes suivantes :

a) on fournit un moule présentant une empreinte limitée par deux faces principales parallèles sensiblement rectangulaire et un bord, lesdites faces principales ayant une largeur de l'ordre de 55 mm et une longueur de l'ordre de 85 mm, la distance séparant lesdites faces principales étant de l'ordre de 0,8 mm, une desdites faces principales étant munie d'une extension pour définir dans ledit corps de carte une cavité d'une profondeur au moins égale à 0,25 mm ;

b) on injecte sous pression dans ladite empreinte un matériau plastique pour réaliser la totalité dudit corps de carte ;

c) on démoule le corps de carte ainsi obtenu ;

d) on fournit un module électronique comprenant une pastille semi-conductrice ;

e) on place ledit module électronique dans ladite cavité et on le fixe audit corps de carte.

De préférence, le matériau utilisé pour l'injection est un acrylonitryl-butadiène-styrène.

L'invention sera mieux comprise à la lecture de la description qui suit de plusieurs modes de mise en oeuvre de l'invention donnés à titre d'exemples non limitatifs. La description se réfère aux dessins annexés sur lesquels :

- la figure 1 est une vue de dessus d'un corps de carte conforme à l'invention ;
- la figure la est une vue de détail de la figure 1 montrant la cavité ménagée dans le corps de carte ;
- la figure 2 est une ocupe partielle selon la ligne II-II de la figure la ;
- la figure 3 est une vue simplifiée en coupe horizontale d'un moule pour réaliser un corps de carte selon l'invention ;
- la figure 4 est une vue en coupe verticale du moule selon la ligne IV-IV de la figure 3 ;
- la figure 5 est une vue en coupe verticale d'un module électronique destinée à être monté sur un corps de carte selon les figures 1 et 2 ;
- les figures 6 et 7 représentent le circuit imprimé du module électronique respectivement en vue de dessus et en vue de dessous ; et

- la figure 8 est une vue partielle de la carte représentant le module électronique implanté dans le corps de carte.

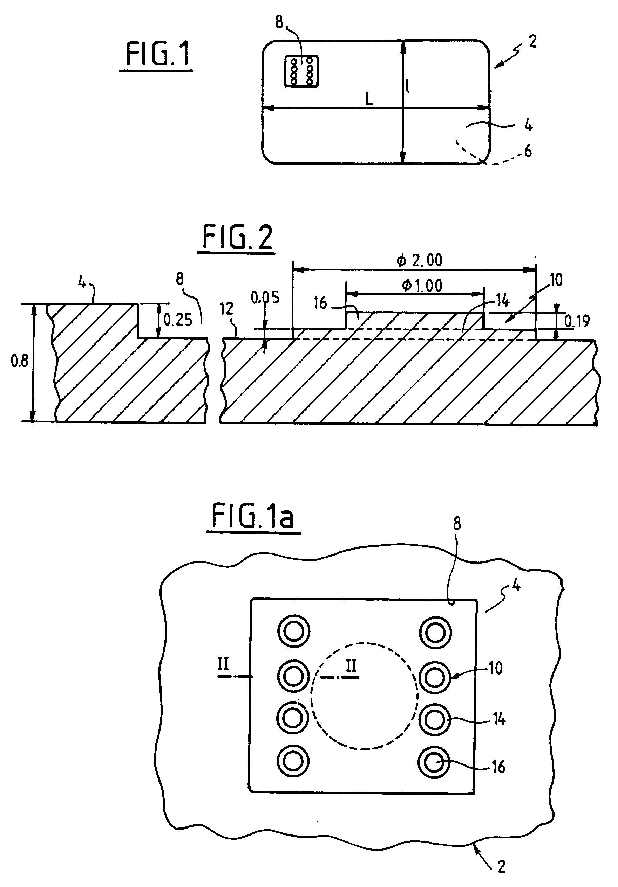

En se référant tout d'abord aux figures 1 à 2, on va décrire une forme de corps de carte réalisé selon l'invention.

Le corps 2 a la forme d'un parallélépipède rectangle présentant deux faces principales 4 et 6 de forme générale rectangulaire. Les dimensions des faces principales sont approximativement de 85 mm (longueur L) et de 55 mm (largeur l) . L'épaisseur du corps de carte est de l'ordre de 0,8 mm. Comme le montre la figure 1 le corps 2 comporte de plus une cavité 8 qui débouche dans la face principale 4. La cavité 8 a une profondeur constante de 0,25 mm, et des dimensions de 11 mm et 13 mm dans le plan de la face principale 4.

La figure 1 montre que la cavité 8 comporte huit picots 10 qui font saillie dans son fond 12. Les picots sont disposés selon deux lignes parallèles.

La figure 2 montre que chaque picot comprend une embase 14 qui a un diamètre de 2 mm et une épaisseur de 0,05 mm et une partie terminale 16 de diamètre 1 mm et d'épaisseur 0,19 mm.

Selon l'invention le corps de carte est réalisé par moulage par injection à chaud. Le matériau plastique utilisé est un acrylonitryl-butadiène-styrène. Le matériau est injecté dans le moule à une température comprise entre 200°C et 300°C,de préférence entre 270 et 290 ° C , et le moule est maintenu à une température comprise entre 5 et 100°C,de préférence entre 10 et 50° C
On pourrait également utiliser d'autres matériaux plastiques tels que le polystyrène ,le polypropylène ,et le polyamine 11 .Dans ce cas , il faudrait modifier les paramètres d'injection .

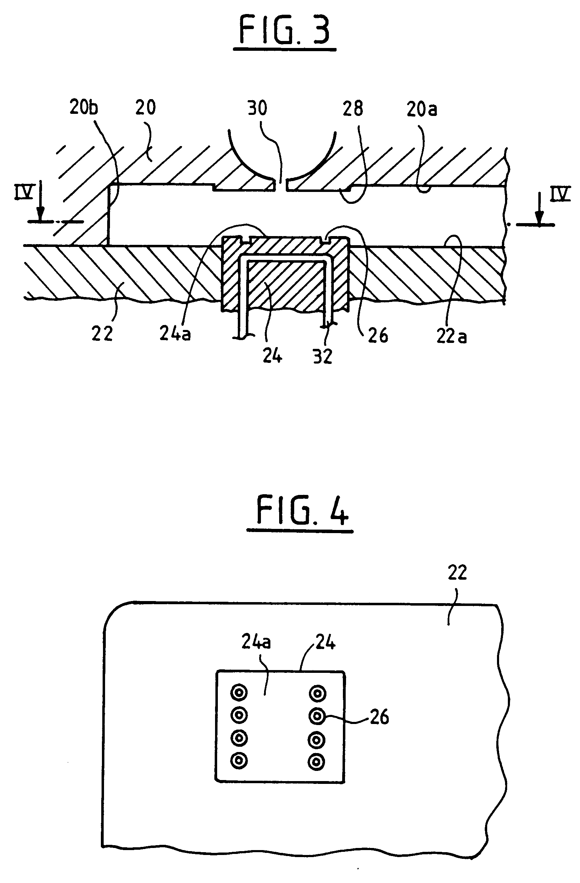

En se reportant aux figures 3 et 4 on v a décrire plus en détail un exemple de moule pour la mise en oeuvre de l'invention. Le moule comprend une partie avant fixe 20 et une partie arrière amovible 22. La partie avant 20 présente une face principale 20a qui définit la face principale 6 du corps de carte et une paroi latérale 20b qui définit le bord de la carte. La partie arrière 22 présente une face 22a qui définit la deuxième face principale 4 du corps de carte. Dans la partie 22 est monté un noyau 24 qui sert à réaliser la cavité 8 et qui occupe dans la face 22a de la partie 22 la même position que la cavité 8 dans la face 4 du corps de carte. La face 24a du noyau 24 dfinit le fond 12 de la cavité et comporte huit évidements étagés 26 qui définissent la forme des picots 10.
Si l'on revient à la partie 20 on voit que la face 20a comporte une portion 28 en légère saillie faisant face au noyau 24. Dans la sailie 28 débouche le canal d'injection 30. Celui-ci débouche vis-à-vis du centre de la face 24a du noyau 24 c'est-à-dire vis-à-vis du centre de la cavité 8. Bien entendu, lorsque les deux parties 20 et 22 sont solidarisées entre elles, l'espace entre elles définit le volume de moulage et donc le corps de la carte. Il faut ajouter que le noyau 24 qui est en regard du point d'injection est muni d'un système de refroidissement figuré par la canalisation 32 de circulation de liquide
Les différents essais réalisés ont montré que le procédé ci-dessus permettait d'obtenir, dans des conditions économiques très satisfaisantes, des corps de carte répondant aux spécifications énoncées précédemment, malgré la forme générale de la pièce peu favorable, notamment son épaisseur trés faible (0,8 mm ).

En particulier grâce à la technique particulière d'injection le corps de carte présente des caractéristiques de tenue en flexion, aussi bien dans sa direction longitudinale (L) que dans sa direction transversale (l), qui répondent aux spécifications de la norme ISO.Plus précisément cette norme impose que ,après 250 flexions avec une flèche égale à 5 mm dans le sens de la largeur et une flèche égale à 10 mm dans le sens de la longueur ,l'épaisseur apparente de la carte reste inférieure à 0,94 mm
En outre, les avantages du procédé selon l'invention apparaissent clairement. Le corps de carte avec la forme particulièrement de sa cavité incluant les picots est obtenu en une seule opération, et les cotes et le positionnement de la cavité sont parfaitement répétitifs.

Si l'on revient à la figure 3, il va de soi que le noyau 24 pourrait être supprimé à condition d'usiner la face 22a de la partie de moule 22 de telle manière qu'elle définisse elle-même une forme correspondant à l'extrémité 24a du noyau. Il faut ajouter encore que le procédé de l'invention peut s'appliquer à la réalisation d'autres formes de corps de carte notamment en ce qui concerne la forme de la cavité ou le nombre de cavités. Dans le cas de corps de carte à plusieurs cavités il pourrait être intéressant de prévoir un point d'injection au droit de chaque cavité.

Un autre avantage important du procédè selon l'invention est que le corps de carte peut être embossé selon des techniques classiques .Or on sait que dans beaucoup d'utilisations de carte il est imposé au constructeur que des informations de personnalisation puissent être inscrites sur une des faces de la carte par embossage.

Il faut également souligner que le corps de carte ainsi obtenu permet la mise en place d'une piste magnétique et l'inscription par serigraphie de dessins ou de mentions littérales .

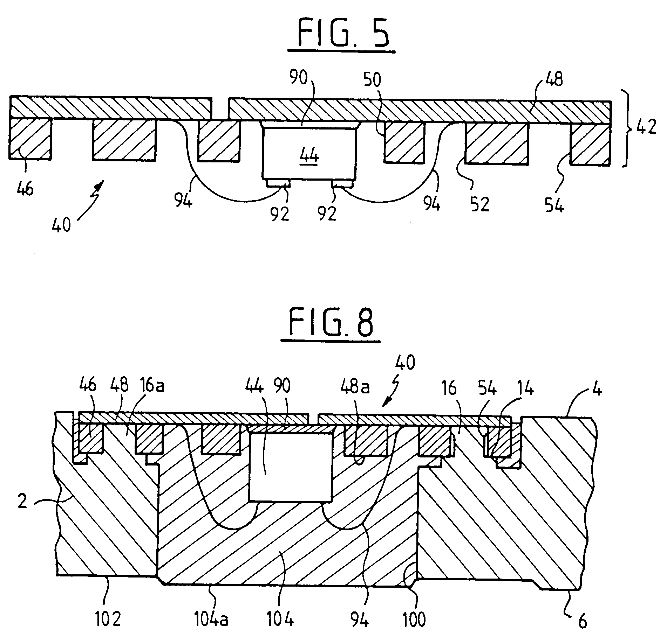

On va maintenant décrire, en se référant aux figures 5 à 8, le procédé de réalisation de la carte à mémoire électronique à partir d'un corps de carte obtenu par moulage selon l'invention.

La figure 5 montre un module électronique 40 qui doit être implanté dans le corps de carte 2. Le module électronique 40 comprend essentiellement un circuit imprimé simple face 42 et une pastille semi-conductrice 44 dans laquelle sont réalisés les circuits électroniques convenables, et notamment les circuits de mémoire.

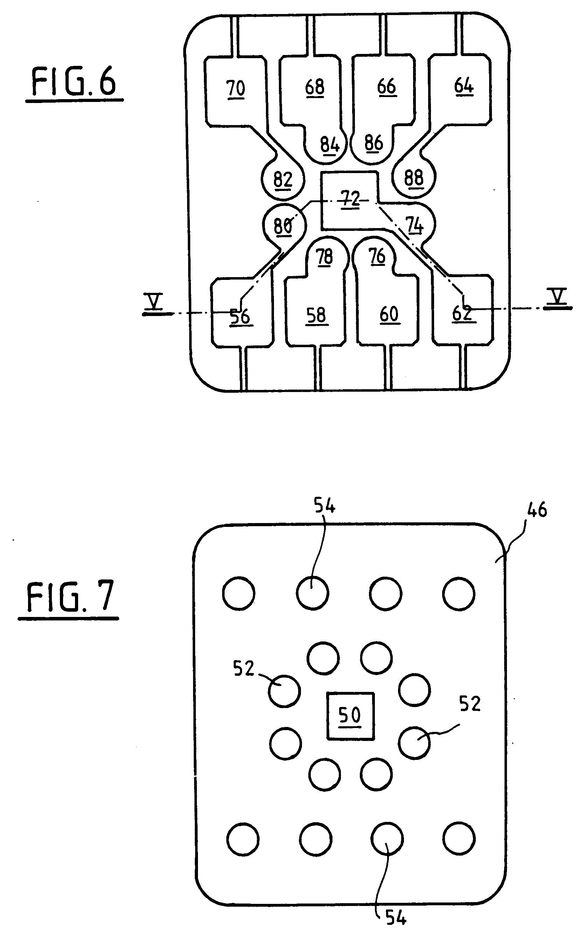

Le circuit imprimé 42 comprend un support isolant 46 en polyester sur une face duquel est formée une couche de matériau conducteur 48, typiquement en cuivre. Comme le montre mieux la figure 7, le support isolant 46 est percé d'une fenêtre centrale 50, de huit trous de "bonding" 52 entourant la fenêtre centrale 50, et de huit trous de pré-accrochage 54. Les huit trous 54 de pré-accrochage occupent la même disposition spatiale que les huit picots 10 du corps de carte, et ils présentent un diamètre très légèrement supérieur au diamètre des parties terminales 16 des picots.

Si l'on se réfère à la figure 6, on voit que la couche de métallisation 48 est gravée pour définir :

a). huit plages de contact électrique 56 à 70 qui sont disposées au-dessus des trous de pré-accrochage ;

b). neuf prises de contact électrique 72 à 88 correspondant à la fenêtre centrale 50 et aux huit trous de bonding 52 ;et

c). des pistes conductrices pour relier chaque prise de contact à une plage de connexion électrique ainsi que la métallisation centrale 72 à la prise de contact 74.

Si l'on se reporte à nouveau à la figure 5, on voit que la pastille semi-conductrice 44 est placée dans la fenêtre centrale 50 et fixée sur la métallisation centrale 72 par de la colle conductrice 90. En outre, chaque borne 92 de la pastille 44 est reliée à une prise de contact 74 à 88 par un fil conducteur 94 dont la deuxième extrémité prénètre dans le trou de bonding 52 correspondant et est soudée sur la face de la prise de contact obturant le fond du trou de bonding. Ainsi chaque borne 92 de la pastille semi-conductrice, ainsi que la face postérieure de celle-ci, est reliée électriquement à une plage de contact.

Le support isolant 46 a une épaisseur de 150 microns et la couche de métallisation 48 a une épaisseur de 50 microns. On observe que l'épaisseur du support isolant du circuit imprimé est inférieure à la hauteur de la partie terminale 16 de chaque picot 10.

La figure 8 illustre l'i,plantation du module électronique 40 dans le corps de carte réalisé par moulage

Dans une étape préalable on perce un trou 100 qui débouche d'une part dans la cavité 8 entre les deux lignes de picots 10 (voir cercle en pointillés sur la figure 1a) et d'autre part dans un évidement 102 ménagé dans la face 6 du corps de carte par la partie en saillie 28 du moule d'injection.

Le module électronique 40 est mis en place dans la cavité 8 du corps 2, de telle manière que les parties terminales 16 des pîcots pénètrent dans les trous de pré-accrochage 54. La face 48a du circuit imprimé n'est pas en contact avec les embases 14 des picots. L'espace restant est de l'ordre de 0,040 mm.

Dans l'étape suivante on chauffe les métallisations 48 au niveau des trous 54 de pré-accrochage. Il en résulte un ramollissement des extrémités des parties terminales 16 des picots qui se déforment en s'élargissant comme le montre la figure 9 en 16 a. Cela provoque un pré-accrochage et un positionnement du module électronique 40 sur le corps de carte 2. En particulier la face 48a du circuit imprimé 42 vient en contact avec les embases 14 des picots 10.

On peut alors retourner le corps de carte pour terminer la fixation du module électronique 40. On fait pénétrer dans le trou 100 de la colle, par exemple une colle époxy (104) thermodurcissable qui remplit le trou 100 et l'espace laissé libre entre le fond 12 de la cavité 8 et le circuit imprimé. On obtient ainsi le collage définitif du module sur le corps de carte et le remplissage du trou 100 ce qui assure en même temps l'enrobage et la protection de la pastille semi-conductrice 44 et des fils de liaison 94. Grace à l'évidement 102 il est possible de fraiser la face 104a du dépôt de colle 104 sans risquer d'abîmer la face 6 proprement dite du corps de carte.

Dans la description précédente on a plus particulièrement considéré la mise en place d'un module électronique du type représenté sur la figure 5. On comprend cependant que le procédé selon l'invention peut s'appliquer à la réalisation de cartes à mémoire électronique comportant d'autres types de modules électroniques. En particulier, au lieu de prévoir des plages de connexion électrique la liaison avec le lecteur de carte pourrait être réalisée par couplage inductif. De même au lieu d'avoir des picots dans le fond de la cavité pour assurer le positionnement et le pré-accrochage du module électronique, on pourait avoir d'autres formes en relief, à condition que celles-ci soient réalisables par moulage.Le procedé peut également être mis en oeuvre sans réaliser le trou 100. Dans ce cas la colle est introduite dans la cavité par la face avant du module électronique ou la colle peut être déposée sur la face postérieure du circuit imprimé avant que le module électronique ne soit mis en place sur le corps de carte .

## Revendications

1. Procédé de réalisation d'une carte à mémoire électronique comprenant un corps de carte (2) ayant des propriétés de flexion satisfaisant à la norme ISO et un module électronique (40) formant un support d'informations, caractérisé en ce qu'il comprend les étapes suivantes :

a) on fournit un moule (20, 22) présentant une empreinte limitée par deux faces principales parallèles (20a, 22e) sensiblement rectangulaires et un bord (20b), lesdites faces principales ayant une largeur (l) de l'ordre de 55 mm et une longueur (L) de l'ordre de 85 mm, la distance séparant lesdites faces principales étant de l'ordre de 0,8 mm, une desdites faces principales (22a) munie d'une extension (24) pour définir dans ledit corps de carte une cavité (8) d'une profondeur au moins égale à 0,25 mm ;

b) on injecte sous pression dans ladite empreinte un matériau plastique pour réaliser la totalité dudit corps de carte ;

c) on démoule le corps de carte ainsi obtenu ;

d) on fournit un module électronique (40) comprenant une pastille semi-conductrice (44);

e) on place ledit module électronique (40) dans ladite cavité (8) et on le fixe audit corps de carte (2).

2. Procédé selon la revendication 1, caractérisé en ce que le matériau plastique d'injection est choisi dans le groupe comprenant l'acrylonitryl-butadiène-styrène, le polystyrène, le polypropylène et le polyamide 11.

3. Procédé selon la revendication 2, caractérisé en ce que ledit matériau plastique d'injection est l'acrylonitryl-butadiène-styrène.

4. Procédé selon la revendication 3, caractérisé en ce que le matériau plastique est injecté à une température comprise entre 270°C et 290°C et en ce que le moule est porté à une température comprise entre 10 et 50°C.

5. Procédé selon l'une quelconque des revendications 1 à 4, caractérisé en ce que ledit module électronique (40) comprend un élément de circuit imprimé (42) comportant un support isolant (46) percé d'une pluralité de trous (54) et des métallisations (48) pour définir lesdites plages de contact électrique, lesdites métallisations obturant une extrémité desdits trous, en ce que, lors de la réalisation du corps de carte, on forme également une pluralité de picots (10) faisant saillie dans ladite cavité (8), on place celui-ci dans ladite cavité pour que lesdits picots pénètrent dans lesdits trous du support isolant, on chauffe localement ledit module pour provoquer le ramollissement et l'écrasement des extrémités desdits picots, ce qui produit un accrochage du module sur le corps de carte, et on introduit de la colle dans ladite cavité pour terminer le collage.

6. Procédé selon l'une quelconque des revendications 1 à 5, caractérisé en ce que l'injection est réalisée par un seul orifice d'injection (30).

7. Procédé selon l'une quelconque des revendications 1 à 6, caractérisé en ce qu'on réalise, sur une face du corps de carte, une inscription de signes par embossage.

8. Procédé selon l'une quelconque des revendications 1 à 7, caractérisé en ce qu'on met en place sur une face principale du corps de carte une piste magnétique.

**Claims**

1. Process for the manufacture of an electronic memory card comprising a card body (2) having bending resistance properties complying with the ISO standard and an electronic module (40) forming a data carrier, characterised in that it comprises the following steps:

a) a mould (20, 22) is provided having a cavity defined by two substantially rectangular parallel main faces (20a, 22a) and an edge (20b), the said main faces having a width (l) of approximately 55 mm and a length (L) of approximately 85 mm, the distance separating the said main faces being approximately 0.8 mm, one of the said main faces (22a) being provided with an extension (24) to define a cavity (8) having a depth at least equal to 0.25 mm in the said card body;

b) a plastic material is injected under pressure into the said cavity in order to manufacture the entire card body;

c) the card body obtained in this manner is removed from the mould;

d) an electronic module (40) is provided comprising a semi-conducting chip (44);

e) the said electronic module (40) is placed in the said cavity (8) and it is fixed to the said card body (2).

2. Process according to claim 1, characterised in that the plastic injection material is selected from the group comprising acrylonitrile-butadiene-styrene, polystyrene, polypropylene and polyamide 11.

3. Process according to claim 2, characterised in that the said plastic injection material is acrylonitrile-butadiene-styrene.

4. Process according to claim 3, characterised in that the plastic material is injected at a temperature included between 270°C and 290°C and that the mould is brought to a temperature included between 10 and 50°C.

5. Process according to any one of claims 1 to 4, characterised in that the said electronic module (40) comprises a printed circuit element (42) having an insulated base (46) provided with a plurality of holes (54) and metallisation (48) in order to define the said electrical contact tabs, the said metallisation covering one end of the said holes, and that, upon the manufacture of the card body, a plurality of pins (10) projecting into the said cavity (8) are also formed, the latter are placed in the said cavity so that the said pins penetrate into the said holes of the insulated base, the said module is locally heated in order to effect softening and deformation of the ends of the said pins, resulting in fastening of the module to the card body, and adhesive is introduced into the said cavity in order to complete gluing.

6. Process according to any one of claims 1 to 5, characterised in that the injection is effected via one single feed orifice (30).

7. Process according to any one of claims 1 to 6, characterised in that symbols are embossed on one face of the card body.

8. Process according to any one of claims 1 to 7, characterised in that a magnetic track is placed on one main face of the card body.

**Patentansprüche**

1. Verfahren zur Herstellung einer Karte mit elektronischem Speicher, die einen Kartenkörper (2) mit Biegeeigenschaften, die der ISO-Norm genügen und ein elektronisches Bauteil (40) umfaßt, das einen Datenträger darstellt, **dadurch gekennzeichnet,** daß es die folgenden Schritte umfaßt
a) man stellt eine Form (20, 22) mit einem durch zwei zueinander parallelen, in etwa rechtwinkligen Hauptflächen (20a, 22a) und einem Rand (20b) begrenzten Freiraum bereit, wobei die Hauptflächen eine Breite (l) in der Größenordnung von 55 mm und eine Länge (L) in der Größenordnung von 85 mm aufweisen und die Entfernung zwischen den Hauptflächen in der Größenordnung von 0,8 mm liegt, und wobei eine der Hauptflächen (22a) mit einer Erweiterung (24) versehen ist, um im Hauptteil der Karte eine Vertiefung (8) mit einer Tiefe von mindestens 0,25 mm festzulegen,
b) man spritzt unter Druck in den Freiraum ein Kunststoffmaterial ein, um den gesamten Kartenkörper herzustellen,
c) man entnimmt den so erhaltenen Kartenkörper,
d) man stellt ein elektronisches Bauteil (40) mit einem Halbleiterplättchen (44) bereit,
e) man setzt dieses elektronische Bauteil (40) in die Vertiefung (8) und befestigt es am Kartenkörper (2).

2. Verfahren nach Anspruch 1, dadurch gekennzeichnet, daß das Kunststoffmaterial zur Einspritzung ausgewählt wird unter Acrylnitril-Butadien-Styrol, Polystyrol, Polypropylen und Polyamid-11.

3. Verfahren nach Anspruch 2, dadurch gekennzeichnet, daß das Plastikmaterial Acrylnitril-Butadien-Styrol ist.

4. Verfahren nach Anspruch 3, dadurch gekennzeichnet, daß das Plastikmaterial bei einer Temperatur zwischen 270 °C und 290 °C eingespritzt wird und daß die Form auf eine Temperatur zwischen 10 und 50 °C gebracht wird.

5. Verfahren nach einem der Ansprüche 1 bis 4, dadurch gekennzeichnet, daß das elektronische Bauteil (40) ein Element aufweist, das eine gedruckte Schaltung (42) ist und das einen isolierenden, mit mehreren Löchern (54) durchbohrten Träger (46) aufweist, und Metallisierungen (48), um die Bereiche für den elektrischen Kontakt festzulegen, wobei die Metallisierungen eine Seite der Löcher abdichten, sowie dadurch, daß man während der Herstellung des Kartenkörpers auch eine Vielzahl von Zapfen (10) ausbildet, die in der Vertiefung (8) hervorstehen, man diese in die Vertiefung (8) setzt, damit die Zapfen in die Löcher des isolierenden Trägers eindringen, man das Bauteil lokal beheizt, um die Erweichung und das Zusammendrücken der Zapfenenden hervorzurufen, was eine Haftung des Bauteils auf dem Hauptteil der Karte bewirkt, und man Klebstoff in die Vertiefung einbringt, um den Klebevorgang zu beenden.

6. Verfahren nach einem der Ansprüche 1 bis 5, dadurch gekennzeichnet, daß die Einspritzung durch eine einzige Einspritzöffnung (30) erfolgt.

7. Verfahren nach einem der Ansprüche 1 bis 6, dadurch gekennzeichnet, daß man auf einer Oberfläche des Kartenkörpers durch Prägung eine Beschriftung mit Zeichen erzeugt.

8. Verfahren nach einem der Ansprüche 1 bis 7, dadurch gekennzeichnet, daß man auf eine Hauptfläche des Kartenkörpers einen Magnetstreifen anbringt.

## FIG.1

## FIG.2

## FIG.1a

# FIG. 3

# FIG. 4

## FIG. 5

## FIG. 8

FIG.6

FIG.7